# EUROPÄISCHE PATENTANMELDUNG

(11) **EP 4 471 821 A1**
(43) Veröffentlichungstag der Anmeldung: **04.12.2024**
(21) Anmeldenummer: 23177063.7
(22) Anmeldetag: 02.06.2023
(51) Int. Cl.: H01J 37/32, C23C 14/34, H01J 37/34

(54) **VERFAHREN ZUM MAGNETRONSPUTTERN**

(71) Anmelder: Melec Gmbh, 76534 Baden-Baden (DE)
(72) Erfinder: Löffler, Jonathan Karl, 77833 Ottersweier (DE); Mark, Günter, 77836 Rheinmünster (DE)
(74) Vertreter: Glück Kritzenberger Patentanwälte PartGmbB

(57) **Zusammenfassung**

Die Erfindung betrifft ein Verfahren zum Abscheiden von Schichten auf einem Substrat mittels Magnetronsputtern in einer Abscheidungskammer (12) unter Verwendung wenigstens eines Magnetrons (16; 16a, 16b), an welchem eine elektrische Versorgungsspannung umfassend drei sich überlagernde elektrische Anregungsformen (60, 62, 64) angelegt wird. Diese umfassen eine erste Anregungsform(60), welches durch eine Hochfrequenz-Spannung mit einer Frequenz von 1 MHz bis 10 GHz gebildet ist, eine zweite Anregungsform (62) in Form hochenergetischer Impulse (HIPIMS) mit einer Frequenz von 100 Hz bis 5 kHz, und eine dritte Anregungsform (64), gebildet durch eine gepulste Gleichspannung oder Mittelfrequenz- Wechselspannung mit einer Frequenz zwischen 10 kHz und 100 kHz.

## Beschreibung

Die vorliegende Erfindung betrifft ein Verfahren zum Abscheiden von Schichten auf einem Substrat mittels Magnetronsputtern in einer Abscheidungskammer unter Verwendung wenigstens eines Magnetrons. Magnetronsputtern ist zum Abscheiden von Schichten wohlbekannt, wobei immer beabsichtigt ist, eine hohe Abscheidungsrate zu erhalten und eine gute und reproduzierbare Prozessführung zu gewährleisten.

Es ist Ziel der vorliegenden Erfindung, das Verfahren zum Abscheiden von Schichten auf einem Substrat mittels Magnetronsputtern zu verbessern, um eine höhere Abscheidungsrate unter reproduzierbaren Prozessbedingungen zu erhalten.

Diese Aufgabe wird mit einem Verfahren gemäß Anspruch 1 und mit einer Magnetronsputteranlage gemäß Anspruch 10 gelöst. Vorteilhafte Weiterbildungen der Erfindung sind Gegenstand der zugeordneten abhängigen Ansprüche. Vorteilhafte Weiterbildungen der Erfindung sind ebenfalls in der Beschreibung als auch in den Zeichnungen offenbart.

Erfindungsgemäß wird in dem Verfahren wenigstens ein Magnetron verwendet, an welchem eine elektrische Versorgungsspannung angelegt wird, die drei sich überlagernde elektrische Anregungsformen aufweist, nämlich eine Hochfrequenz (RF)-Spannung mit einer Frequenz von 1 MHz bis 10 GHz, eine zweite Anregungsform in Form hochenergetischer Impulse (HIPIMS) mit einer Frequenz zwischen 100 Hz und 5 kHz, und eine dritte Anregungsform, gebildet durch eine gepulste Gleichspannung oder Wechselspannung mit einer Frequenz zwischen 10 kHz und 100 kHz. Es hat sich herausgestellt, dass die überlagernde Anregung des Magnetrons mit den oben beschriebenen drei Anregungsformen zu einer äußerst hohen Ionisierung im Plasma und zu einem guten Abtrag der Kathode führt, was zu höheren Abscheidungsraten, einer besseren Beschichtungsanhaftung und härteren Beschichtungen als auch dichteren Dünnschicht-Filmen auf dem Substrat mit einstellbaren Eigenschaften führt.

Insbesondere lassen sich defektfreie Schichten herstellen, was vor Allem bei hochisolierenden Schichten wichtig ist, da dort die Entstehung von elektrisch leitenden Einschlüssen, den so genannten Pin-holes zu vermeiden ist, welche die isolierende Schicht unbrauchbar machen können. Dies ist durch eine gezielte simultane Anwendung der drei Anregungsformen möglich, so dass insbesondere fehlerfreie hochisolierende Schichten, z.B. Al₂O₃-Schichten durch die Erfindung realisierbar sind.

Wichtig ist allein, dass das Magnetron mit allen drei Anregungsformen gleichzeitig beaufschlagt wird. Die drei Anregungsformen können über eigene Generatoren bzw. Energieversorgungen oder über eine gemeinsame Energieversorgung bereitgestellt werden, die in der Lage ist, alle drei Anregungsformen generieren bzw. zu liefern.

Prinzipiell ist eine zeitliche Synchronisierung der drei Anregungsformen nicht notwendig, jedoch hat es sich als vorteilhaft erwiesen, wenn wenigstens zwei der drei Anregungsformen, vorzugsweise alle drei Anregungsformen, zeitlich synchronisiert zugeführt werden. Dies führt zu einer höheren Ionisierung und damit zu einer stärkeren Abtragung der Targetkathode und zu einer besseren Prozessstabilität und Reproduzierbarkeit der Ergebnisse.

Vorzugsweise haben die hochenergetischen Impulse (HIPIMS) eine Impulsdauer von mehr als 10 µs und eine Pulsleistung zwischen 15 kW und 10 MW. Auf diese Weise kann eine hohe Leistung in das Plasma eingebracht werden, was zu einer hohen Ionisierung und zu entsprechend hohen Abtragungsraten der Targetkathode führt.

Ein in der Abscheidungskammer angeordneter Substratträger ist vorzugsweise mit einem elektrischen Bias-Signal beaufschlagt, das die Abscheidung der im Plasma vorhandenen Atome der Targetkathode auf dem Substrat verbessert, obwohl das Verfahren auch funktioniert, wenn der Substrathalter nicht mit einem Bias-Signal beaufschlagt ist.

Vorzugsweise ist das Bias-Signal mit wenigstens einem der drei Anregungsformen des Magnetrons synchronisiert. So kann beispielsweise ein Pulssignal immer zeitlich kurz versetzt hinter dem HIPIMS-Puls der Anregungsform auf den Substrathalter gegeben werden. Mit der zeitlichen Versetzung möchte man erreichen, dass möglichst nur Metallionen des Targets nicht aber die Gasionen des inerten Prozessgases (z.B. Ar) im Substrat implantiert werden.

Generell können als Bias-Signal ein DC-Signal, ein Hochfrequenz-Signal und/oder ein Pulssignal verwendet werden. Das Bestreben ist immer, durch die Bias-Beaufschlagung des Substrathalters die Wanderung beziehungsweise die Beschleunigung der Ionen aus dem Plasma in Richtung auf den Substrathalter zu verbessern.

Prinzipiell kann in dem Verfahren ein einzelnes Magnetron oder mehrere Magnetrons, zum Beispiel ein Dual-Magnetron, verwendet werden. Falls ein einzelnes Magnetron verwendet wird, ist das Bezugspotenzial für alle drei Anregungsformen vorzugsweise das Erdpotenzial. Falls ein Dual-Magnetron verwendet wird, wird vorzugsweise die Kathode des anderen Magnetrons als Bezugspotenzial verwendet.

Es erübrigt sich zu sagen, dass die Abscheidungskammer immer auf dem Erdpotenzial liegt, und dass das Bezugspotenzial für die Bias-Spannungsbeaufschlagung des Substrathalters ebenfalls das Erdpotenzial ist.

In einer Ausführungsform der Erfindung, die zu besonders hohen lonisierungsraten im Plasma und zu entsprechend hohen Abscheidungsraten führt, werden bei den HIPIMS-Signalen der zweiten Anregungsform vor den hochenergetischen Impulsen kurze Vorimpulse abgegeben, um die Ionisierung in der Abscheidungskammer zu erhöhen. Es hat sich herausgestellt, dass diese Impulsform zu einer nochmaligen Verbesserung der Ionisierung im Plasma in der Abscheidungskammer führt.

Es ist für das Magnetron-Sputtern selbstverständlich, dass die Abscheidungskammer weitgehend unter Vakuum gehalten ist und mit einem Sputtergas wie Argon oder z.B. Stickstoff durchflutet wird, was an sich bekannt ist und daher hier nicht weiter ausgeführt wird.

Die Erfindung betrifft ebenfalls eine Magnetronsputteranlage zum Abscheiden von Schichten auf einem Substrat, umfassend eine Abscheidungskammer, eine Substrathalterung, als auch wenigstens ein in der Abscheidungskammer angeordnetes Magnetron, das mit wenigstens einer Energieversorgung verbunden ist, deren Ausgang drei Anregungsformen an das wenigstens eine Magnetron abgibt, umfassend eine erste Anregungsform, die durch eine Hochfrequenz-Spannung mit einer Frequenz von 1 MHz bis 10 GHz gebildet ist, eine zweite Anregungsform, die gebildet ist durch hochenergetische Impulse (HIPIMS) mit einer Frequenz von 100 Hz bis 5 kHz, und eine dritte Anregungsform, gebildet durch eine gepulste Gleichspannung oder Wechselspannung mit einer Frequenz zwischen 10 kHz und 100 kHz. Hinsichtlich der Wirkungsweise und Vorteile der Überlagerung der Anregungsformen wird auf die Beschreibung des Verfahrens weiter oben Bezug genommen. Auch hier ist es selbstverständlich, dass der Druck in der Abscheidungskammer gegenüber dem Normaldruck stark abgesenkt ist und dass die Abscheidungskammer mit einem Sputtergas wie beispielsweise Argon oder Stickstoff geflutet wird, wobei die Flutung der Abscheidungskammer mit einem Sputtergas generell durch einen Massendurchflussregler gesteuert wird. Auf diese Weise kann die Menge des der Abscheidungskammer zugeführten Sputtergases und eines reaktiven Gases geregelt werden. Als Regelgröße können Signale von an sich bekannten Messgeräten, wie zum Beispiel ein optisches Emissionsspektrometer oder eine Lambdasonde, verwendet werden, die in der Lage sind, wenigstens einen Prozessparameter zur Steuerung des Verfahrens, zum Beispiel die Menge des reaktiven Gases im Prozess, darzustellen. Vorzugsweise ist deshalb die Abscheidungskammer auch mit einem optischen Emissionsspektrometer (OES) verbunden, welches dazu dient, Wellenlängeninformationen bereitzustellen, die Auskunft geben über die Intensität und den Ionisierungsgrad des Plasmas. Das optische Emissionsspektrometer kann neben der Plasmadiagnostik auch zur Prozessregelung eingesetzt werden.

Optional sind die Kathoden der Magnetrons mit einer ringförmigen Anode umgeben, die wahlweise schaltbar ist, wodurch die Verteilung des Plasmas im Innenraum der Abscheidungskammer zusätzlich beeinflusst werden kann.

Generell lässt sich ausführen, dass bei der Kathodenzerstäubung oder auch einem Sputterprozess schwere Gasionen, wie zum Beispiel Argon, verwendet werden, um eine Kathode (Target) des Magnetrons zu erodieren. Dieses abgetragene Material geht in ionisierter Weise dann in das in der Abscheidungskammer enthaltene Plasma über und kondensiert auf dem Substrat. Beim Magnetronsputtern werden diese Ionen durch eine Gasentladung generiert. Dazu wird eine hohe Gleich- oder Wechselspannung und auch Hochenergieimpulse zwischen Kathode und Anode generiert, welche Letztere meist mit der Kammermasse, das heißt Erde, verbunden ist. Der ganze Prozess findet in einem Hochvakuum statt, damit die Stoßprozesse ungehindert ablaufen können und um mögliche Verunreinigungen zu reduzieren. Hinter der Kathode des Magnetrons angeordnete Magnete bewirken, dass vorhandene freie Elektrone im Plasma sich nahe an der Kathodenoberfläche platzieren. Dies erhöht die Kollisionsrate mit den Sputtergasatomen, zum Beispiel Argon, erheblich und erhöht damit auch die Abscheidungsrate. Die durch Kollision zwischen den freien Elektronen und den Sputtergasatomen entstandenen positiv geladenen Sputtergasionen werden auf die negativ geladene Targetoberfläche des Magnetrons beschleunigt. Diese hochenergetische Kollision mit der Kathode führt dazu, dass Atome des Kathodenmaterials ausgestoßen werden, um sich dann in Richtung auf das Substrat zu bewegen.

Beim Magnetronsputtern unterscheidet man zwischen Einzel-Magnetronsputtern und Dual-Magnetronsputtern. Bei Ersterem wird zwischen einer einzelnen Kathode und Anode mittels einer Energieversorgung eine hohe Gleich- oder Wechselspannung angelegt. Die Anode ist hierbei meist mit der Kammermasse verbunden. Beim Dual-Magnetronsputtern wird zwischen zwei Magnetrons mittels wenigstens einer Energieversorgung eine hohe Wechselspannung angelegt. Für die positive Halbwelle bildet das erste Magnetron A die Kathode, während das zweite Magnetron B als Anode dient, während es bei der negativen Halbwelle umgekehrt ist.

Wird zusätzlich eine Hochfrequenz überlagert, so wird bei jeder Kathode ein Hochfrequenzgenerator zwischen der Kathode und der Kammermasse geschaltet.

Dual-Magnetrons werden insbesondere eingesetzt, wenn zusätzlich zum Sputtergas ein reaktives Gas, wie zum Beispiel Sauerstoff, in die Abscheidungskammer eingeleitet wird.

Der Vorteil des Dual-Magnetrons gegenüber dem Einzel-Magnetron ist, dass man keine explizite Anode benötigt. Bei der Einzelkathode des Einzel-Magnetrons kommt es während des Prozesses dazu, dass die Anode zunehmend mit dem nicht elektrisch leitfähigen Produkt aus Targetmaterial (Material der Targetkathode des Magnetrons) und Reaktivgas belegt wird. Hierdurch wird die Anodenfläche effektiv immer kleiner und es kann dadurch sogar zum völligen Ausfall des Prozesses kommen (disappearing anode problem). Da bei dem Dual-Magnetron die Kathode ständig alternierend die Rolle der Anode einnimmt, wird immer eine Kathode während der Zerstäubungsphase gereinigt.

Vorzugsweise enthält die Magnetronsputteranlage eine Synchronisationseinrichtung zur Synchronisierung von wenigstens zwei der drei Anregungsformen, welche dem Magnetron, das heißt einem Einzel-Magnetron oder einem Dual-Magnetron, zugeführt werden. Auf diese Weise kann der Prozess besser gesteuert werden, und es werden bessere und reproduzierbare Abscheidungsraten erhalten.

Vorzugsweise ist die Substrathalterung gegenüber der Abscheidungskammer isoliert und mit wenigstens einer BIAS-Energieversorgung verbunden, welche in der Lage ist, die Substrathalterung und damit das Substrat mit einer Gleichspannung, einer Hochfrequenzspannung oder einem Pulssignal zu beaufschlagen, um die Deposition der aus dem Target herausgeschlagenen Atome auf dem Substrat zu verbessern. Vorzugsweise ist hierbei die Synchronisationseinrichtung ausgebildet, die BIAS-Energieversorgung mit wenigstens einer Energieversorgung der drei Anregungsformen des Magnetrons zu synchronisieren, wodurch die Abscheidung deutlich verbessert werden kann.

Die BIAS-Energieversorgung ist somit vorzugsweise ausgebildet, folgende Ausgangsspannungen an die Substrathalterung abzugeben: Gleichspannung, Hochfrequenzwechselspannung mit einer Frequenz von 1 MHz bis 10 GHz und/oder hochenergetische Impulse mit einer Frequenz von 10 kHz bis 200 kHz.

Vorzugsweise weißt die Magnetronsputteranlage Hochfrequenzfilter auf, da in der vorliegenden Erfindung ein Hochfrequenzgenerator mit einem HIPIMS/Mittelfrequenzgenerator parallel betrieben wird. Auf diese Weise wird wirksam verhindert, dass die im Prozess eingesetzte Hochfrequenz, beispielsweise 14 MHz, sowie ihre Oberwellen in die Leitungskabel des HIPIMS/Mittelfrequenzgenerators oder dessen Elektronik eingekoppelt wird. Ohne Filter könnte Hochfrequenz über die Kabel in den freien Raum abgestrahlt werden. Unkontrolliert fließende Hochfrequenzströme können zu Schäden bei den Maschinen als auch in der Magnetronsputteranlage führen.

Schließlich werden noch, wie es im Zusammenhang mit der nachfolgenden Beschreibung ausgeführt wird, Anpassungsnetzwerke verwendet, um die Impedanz des Hochfrequenzgenerators an die Lastimpedanz im Plasma anzupassen. Dieses Netzwerk, kurz Matchbox genannt, passt die Eingangsimpedanz der Last, das heißt des Plasmas, an die Ausgangsimpedanz der Quelle, das heißt des Hochfrequenzgenerators an. Dies reduziert die reflektierte Leistung auf ein Minimum und stellt somit sicher, dass die maximal mögliche Hochfrequenzleistung vom Hochfrequenzgenerator in das Plasma übertragen wird, was zu einem effizienteren Sputterprozess führt.

Folgende Begriffe werden synonym verwendet: Kathodenstrahlzerstäuben - Sputtern; Targetkathode - Kathode des Magnetrons; Synchronisationseinrichtung - Steuerung;
Die Erfindung wird nachfolgend beispielsweise anhand der schematischen Zeichnung beschrieben. In dieser zeigen:
- Fig. 1: ein Prinzipschaltbild einer Magnetronsputteranlage mit einem Einzel-Magnetron,
- Fig. 2: ein Prinzipschaltbild einer Magnetronsputteranlage mit einem Dual-Magnetron,
- Fig. 3: die prinzipielle Ausbildung der Kathode und Anode des Einzel-Magnetrons aus Fig. 1,
- Fig. 4: ein Zeitspannungsdiagramm über die an die Kathode nach Fig. 3 abgegebenen überlagerten Anregungsformen,
- Fig. 5: ein Diagramm gemäß Fig. 4 mit zeitlich synchronisierten Anregungsformen,
- Fig. 6: eine detailliertere Darstellung des Dual-Magnetrons aus Fig. 2,
- Fig. 7: ein Spannungs/Zeit-Diagramm der an ein Dual-Magnetron abgegebenen Spannungen,
- Fig. 8: eine Darstellung gemäß Fig. 7 mit drei zeitlich synchronisierten Anregungsformen.

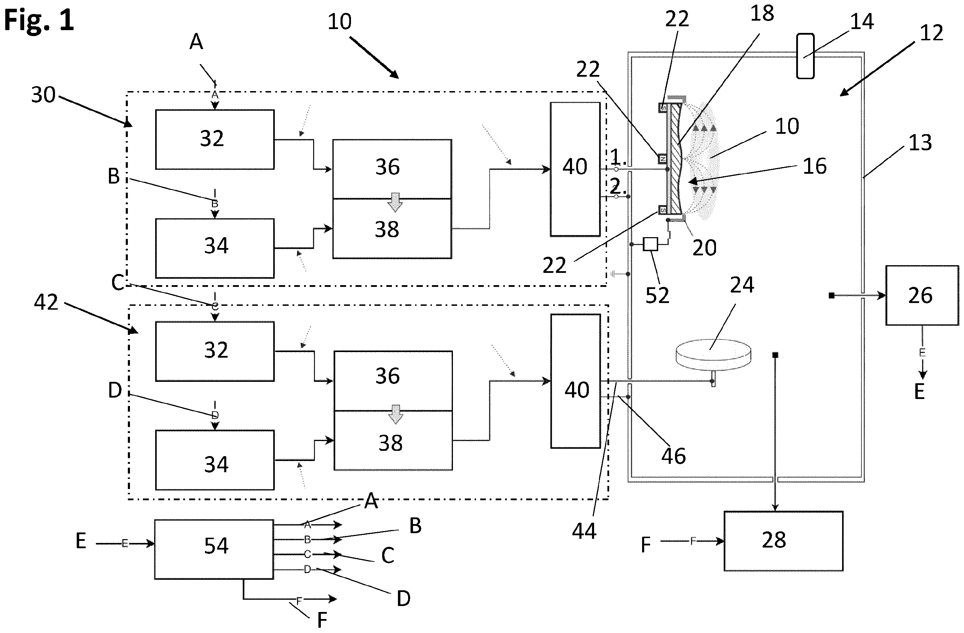

Fig. 1 zeigt eine Magnetronsputteranlage 10 mit einer unter Hochvakuum stehende Abscheidungskammer 12, welche eine Sputtergas- und Reaktivgaszufuhr 14 aufweist. In der Abscheidungskammer 12 ist ein Magnetron 16 angeordnet, welches eine flächige kreisrunde oder anders geformte Targetkathode 18 umfasst, die von einer Ringanode 20 umgeben ist. An der Rückseite der Kathode 18 sind Magneten 22 des Magnetrons angeordnet, um die durch das Zusammenwirken mit dem zum Magnetfeld senkrecht gerichteten magnetischen Feld die im Plasma befindlichen Ionen auf eine Spiralbahn zu leiten, was zu einer erhöhten Zahl an Zusammenstößen mit den Atomen des Sputtergases bzw. Reaktivgases führt. In der Abscheidungskammer 12 ist weiterhin eine Substrathalterung 24 angeordnet als auch die Sensorik eines optischen Emissionspektrometers (OEM) 26 und eines Massendurchflussreglers 28. Die Kathode 18 des Magnetrons 16 ist mit einer Energieversorgung 30 verbunden, die folgende Komponenten aufweist: einen DC- oder Pulsgenerator 32, einen Hochfrequenzgenerator 34, einen Hochfrequenzfilter 36, ein Anpassungsnetzwerk 38 und ein Messsystem 40. Das Anpassungsnetzwerk 38 ist vorgesehen, um die Hochfrequenzspannung des Hochfrequenzgenerators 34 an die Lastimpedanz des in der Abscheidungskammer 12 vorhandenen Plasmas 17 anzupassen. Auf diese Weise wird eine effektive Leistungseinbringung der Hochfrequenzspannung in das Plasma gewährleistet. Der DC/Pulsgenerator 32 geht über einen Hochfrequenzfilter 36 auf das Anpassungsnetzwerk 38, wodurch verhindert wird, dass die von dem Hochfrequenzgenerator 34 erzeugte Hochfrequenzspannung in die Komponente des DC/Pulsgenerators eingekoppelt wird oder einstrahlt. Die Anregungsformen des DC/Pulsgenerators sind hochenergetische Impulse, HIPIMS, und ein Mittelfrequenzsignal im Bereich von 10 bis 100 kHz, welches auf die Kathode 18 des Magnetrons 16 gelegt wird. Diese beiden Anregungsformen werden überlagert mit der Hochfrequenzspannung von dem Hochfrequenzgenerator 34, so dass an der Kathode 18 des Magnetrons 16 drei Anregungsformen überlagert sind, die zum einen zu einer hohen Ionisierung des Plasmas und zu einer Verbesserung der Erodierung des Kathodenmaterials und damit letztendlich zu einer besseren Abscheidung auf dem in der Substrathalterung 24 befindlichen Substrat führen.

Das Messsystem 40 erfasst die von den beiden Spannungsversorgungen, DC/Pulsgenerator 32 und Hochfrequenzgenerator 34, erzeugten Anregungsformen zur Überwachung und Darstellung und zur Steuerung der Anlage. Die Substrathalterung 24 ist mit einer BIAS-Energieversorgung 42 verbunden, welche sich in gleicher Weise zusammensetzt wie die Energieversorgung 30 für das Magnetron 16. Im Unterschied zur Energieversorgung 30 des Magnetrons 16 erzeugt hier der DC/Pulsgenerator 32 der BIAS-Energieversorgung nur eine Gleichspannung, eine Mittelfrequenz oder eine Pulsfrequenz und nicht wie der DC/Pulsgenerator in der Energieversorgung 30 des Magnetrons 16 eine Mittelfrequenz und eine Pulsfrequenz. Während ein erster Anschluss 44 der BIAS-Energieversorgung 42 mit der Substrathalterung 24 elektrisch verbunden ist, ist der zweite Anschluss 46 auf das Gehäuse der Abscheidungskammer 12 und damit auf Erde gelegt.

Bei der Energieversorgung 30 für das Magnetron 16 ist ein erster Anschluss 1 an die Kathode gelegt, während der zweite Anschluss 2 auf das Gehäuse der Abscheidungskammer und damit auf Erde gelegt ist. Die Ringanode 20, welche die Kathode 18 des Magnetrons 16 umgibt, ist über einen Schalter 52 auf das Gehäuse der Abscheidungskammer 12 und damit auf Erde legbar. Das Schließen dieses Schalters verbindet den Anodenring 20 mit Erde und somit mit dem anderen Anschluss 2 der Energieversorgung, was wiederum Auswirkungen auf das Plasma vor der Kathode hat.

Schließlich enthält die Magnetronsputteranlage 10 eine Synchronisationseinrichtung 54, welche als Eingangssignal und als Steuergröße die Information des optischen Emissionsspektrometers erhält, sprich Wellenlängeninformation, Intensität und Ionisierungsgrad der Sputterteilchen im Plasma, und regelt über die Ausgänge A,B,C,D die beiden DC/Pulsgeneratoren und Hochfrequenzgeneratoren der Energieversorgung 30 für das Magnetron und der BIAS-Energieversorgung 42 für den Substrathalter als auch den Massendurchflussregler 28 zur Einstellung des gewünschten Sputtergas- bzw. Reaktivgasstroms über den Einlass 14.

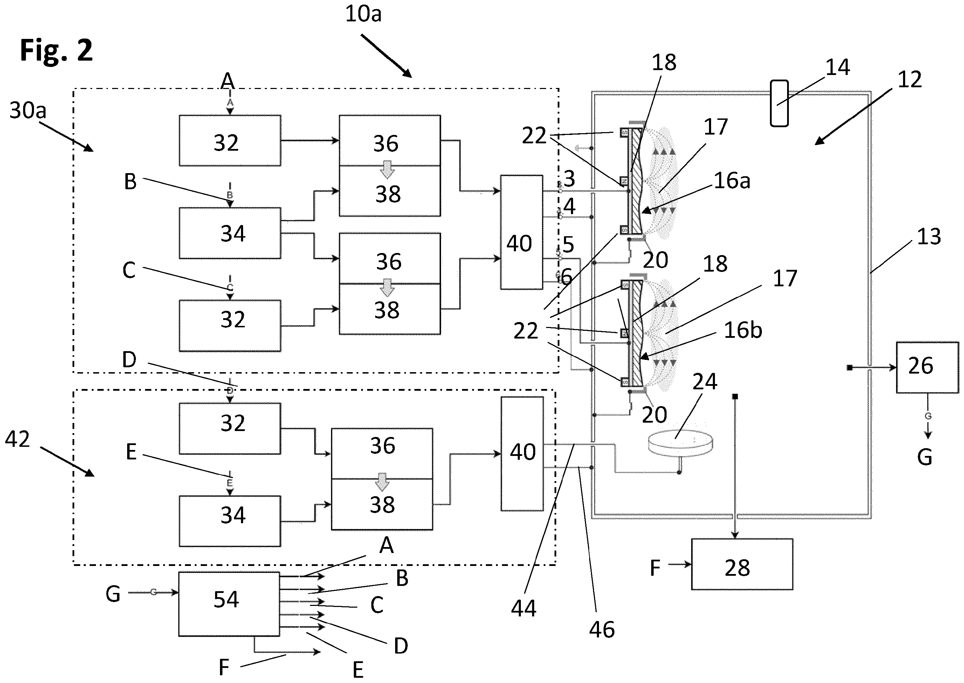

Fig. 2 zeigt eine Magnetronsputteranlage 10a, die weitgehend identisch zur Magnetronsputteranlage 10 aus Fig. 1 aufgebaut ist, mit dem Unterschied, dass diese Magnetronsputteranlage 10a der Fig. 2 zwei Magnetrons 16a, 16b enthält. Es handelt sich somit um ein Dual-Magnetron-System. Zur Fig. 1 identische oder funktionsgleiche Teile werden hierbei mit den identischen Bezugszeichen versehen. Die ersten Anschlüsse 3 und 5 des Ausgangs der Energieversorgung 30a sind mit beiden Kathoden 18a, 18b verbunden. Die zweiten Anschlüsse 4 und 6 der Energieversorgung 30a sind mit dem Gehäuse 13 der Abscheidungskammer verbunden, und damit geerdet bzw. auf Masse gelegt.

Die Energieversorgung 30a für die beiden Magnetrons 16a und 16b unterscheidet sich dadurch von der Energieversorgung 30 aus Fig. 1, dass in dieser Energieversorgung für das erste Magnetron 16a ein erster Hochfrequenzgenerator 32a und für das Magnetron 16b ein zweiter Hochfrequenzgenerator 32b ausgebildet ist, während der DC/Pulsgenerator 34 beide Magnetrons 16a, 16b speist. Bei diesem Dual-Magnetron-System 10a ist vorzugsweise das Bezugspotenzial für die beiden Magnetron-Kathoden 18a, 18b nicht das Erdpotenzial beziehungsweise das Gehäuse der Abscheidungskammer 12 ist, sondern jeweils die Kathode 18b, 18a des anderen Magnetrons 16b, 16a.

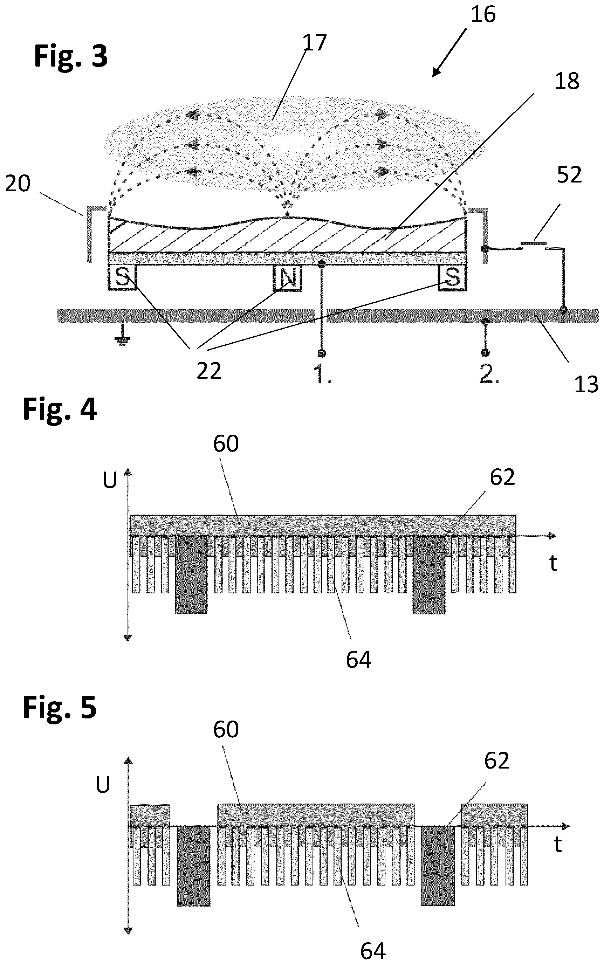

Fig. 3 stellt eine vergrößerte Anordnung des Magnetrons 16 aus Fig. 1 dar. Die Anschlüsse 1 und 2 aus der Energieversorgung 30 sind zum einen an die Kathode 18 des Magnetrons 16 gelegt und zum anderen an das Gehäuse 13 der Abscheidungskammer 12. Über den Schalter 52 kann auch der Anodenring 20 des Magnetrons 16 auf Masse gelegt werden, was Auswirkungen auf die Ausrichtung des Plasmas 17 hat. In der Zeichnung sind mit gestrichelten Linien und Pfeilen die Magnetfeldlinien zwischen den Magneten 22 an der Rückseite der Kathode dargestellt.

Fig. 4 zeigt den Verlauf der Spannung U über die Zeit t (in µs) der Magnetronsputteranlage 10 aus Fig. 1. In diesem Fall sind alle drei Anregungsformen, nämlich ein Hochfrequenzsignal 60, ein HIPIMS-Signal 62 und ein Mittelfrequenzsignal 64 als die drei Anregungsformen für den Betrieb des Magnetrons dargestellt. Die drei Anregungsformen 60, 62 und 64 sind nicht synchronisiert, so dass sie sich alle zeitlich überlappen.

Im Gegensatz dazu zeigt Fig. 5 ein Spannungs/Zeit-Diagramm, bei welchem über die Synchronisationseinrichtung 54 eine Synchronisation dahingehend stattfindet, dass während der Zuführung der HIPIMS-Pulse 62 die Zuführung des Hochfrequenzsignals 60 als auch des Mittelfrequenzsignals 64 unterbrochen sind.

In einem konkreten Fall wurde eine Aluminiumoxid (Al2O3) Testbeschichtung auf einem Silizium Wafer mit folgenden Parametern durchgeführt. Hipims 62 mit einer Frequenz von 704Hz (20us On / 1400us Off) einer Spannungslage von 700V Spitze bei einer gemittelten Leistung von 1000W.

In den Pausezeiten des Hipims Pulses wurde eine Mittelfrequenz 64 mit einer Spannungslage von 700V Spitze bei einer gemittelten Leistung von 500W mit einer Frequenz von 10kHz unterlagert. Beiden vorangehenden Anregungsformen 62, 64 wurde eine Hochfrequenz-Anregungsform mit einer Frequenz von 13,65Mhz einer Spannungslage von 270V Spitze und einer gemittelten Leistung von 1000W überlagert. Auf diese Weise ließen sich dichte, homogene und harte AI2O3-Schichten auf dem Silizium erzeugen, ohne Pin-holes und Einschlüsse.

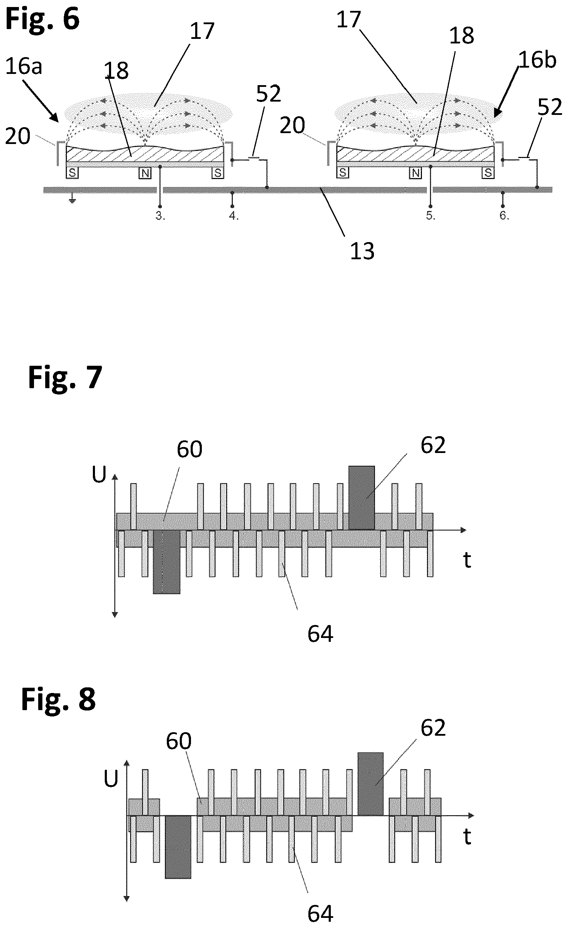

Fig. 6 zeigt eine detailliertere Darstellung des Dual-Magnetrons mit den beiden Magnetrons 16a und 16b aus Fig. 2. Auch hier sieht man deutlicher den Schalter 52, um den Anodenring 20 der beiden Magnetrons 16a und 16b mit Masse und den Anschlüssen 4 und 6 der Energieversorgung 30a zu verbinden.

Fig. 7 zeigt die von dem Messsystem 40 gemessene Ausgangsspannung der Energieversorgung für beide Magnetrons umfassend die Hochfrequenzanregung 60, die HIPIMS-Impulse 62 und die Mittelfrequenz 64. Durch die Tatsache, dass bei der Pulsabgabe als Bezugspotenzial immer die Kathode des anderen Magnetrons verwendet wird, ergeben sich hier Pulsmuster in beide Polrichtungen. Fig. 7 zeigt wieder die nicht synchronisierten Signale, während Fig. 8 analog zu Fig. 5 die Synchronisation dahingehend zeigt, dass für die Dauer der HIPIMS-Impulse 62 die Abgabe der Hochfrequenzanregung 60 und der Mittelfrequenzanregung 64 unterbrochen ist.

Die Erfindung ist nicht auf das dargestellte Ausführungsbeispiel beschränkt, sondern kann innerhalb des Schutzbereichs der beiliegenden Ansprüche variiert werden.

### Bezugszeichenliste:

- 10: Magnetronsputteranlage mit einem Magnetron
- 10a: Magnetronsputteranlage mit einem Dual-Magnetron
- 12: unter Hochvakuum stehende Abscheidungskammer
- 13: (geerdetes) Gehäuse der Abscheidungskammer
- 14: Zufuhr für Sputtergas (z.B. Argon) und optional für wenigstens ein Reaktivgas (z.B. Sauerstoff)
- 16: Magnetron
- 16a: erstes Magnetron eines Dual-Magnetrons
- 16b: zweites Magnetron eines Dual-Magnetrons
- 17: Plasma vor dem Magnetron in der Abscheidungskammer
- 18: (Target-)Kathode des Magnetrons
- 18a: (Target-)Kathode des ersten Magnetrons eines Dual-Magnetrons
- 18b: (Target-)Kathode des zweiten Magnetrons eines Dual-Magnetrons
- 20: (zuschaltbare) Ringanode um die Kathode des Magnetrons
- 22: Magnete des Magnetrons an der Rückseite der Kathode
- 24: Substrathalterung
- 26: optisches Emissionsspektrometer
- 28: Massendurchflussregler
- 30: Energieversorgung des Magnetrons
- 30a: Energieversorgung der beiden Magnetrons eines Dual-Magnetrons
- 32: Hochfrequenzgenerator
- 32a: Hochfrequenzgenerator der Energieversorgung des ersten Magnetrons eines Dual-Magnetrons
- 32b: Hochfrequenzgenerator der Energieversorgung des zweiten Magnetrons eines Dual-Magnetrons
- 34: DC/Pulsgenerator der Energieversorgung
- 36: Hochfrequenzfilter
- 38: Anpassungsnetzwerk zur Impedanzanpassung für die Hochfrequenzeinspeisung ins Plasma
- 40: Messsystem für das Ausgangssignal der Energieversorgung
- 42: BIAS-Energieversorgung
- 44: erster Anschluss der BIAS-Energieversorgung an der Substrathalterung
- 46: zweiter Anschluss der BIAS-Energieversorgung an der Masse des Gehäuses 13 der Abscheidungskammer
- 52: Schalter zum Verbinden der Ringanode des Magnetrons mit dem Gehäuse.
- 60: erste Anregungsform der Energieversorgung (Hochfrequenz)
- 62: zweite Anregungsform der Energieversorgung (HIPIMS)
- 64: dritte Anregungsform der Energieversorgung (Mittelfrequenz)

## Patentansprüche

1. Verfahren zum Abscheiden von Schichten auf einem Substrat mittels Magnetronsputtern in einer Abscheidungskammer (12) unter Verwendung wenigstens eines Magnetrons (16; 16a, 16b), an welchem eine elektrische Versorgungsspannung umfassend drei sich überlagernde elektrische Anregungsformen (60, 62, 64) angelegt wird, umfassend eine erste Anregungsform (60), welche durch eine Hochfrequenz mit einer Frequenz von 1 MHz bis 10 GHz gebildet ist, eine zweite Anregungsform (62) in Form hochenergetischer Impulse (HIPIMS) mit einer Frequenz von 100 Hz bis 5 kHz, und eine dritte Anregungsform (64), gebildet durch eine gepulste Gleichspannung oder Wechselspannung mit einer Frequenz zwischen 10 kHz und 100 kHz.

2. Verfahren nach Anspruch 1, **dadurch gekennzeichnet, dass** wenigstens zwei der drei Anregungsformen (60, 62, 64), vorzugsweise alle drei Anregungsformen zeitlich synchronisiert zugeführt werden.

3. Verfahren nach Anspruch 1 oder 2, **dadurch gekennzeichnet, dass** die hochenergetischen Impulse (HIPIMS) eine Impulsdauer von mehr als 10 µs und eine Pulsleistung zwischen 15 kW und 10 MW aufweisen.

4. Verfahren nach einem der vorhergehenden Ansprüche, **dadurch gekennzeichnet, dass** ein in der Abscheidungskammer (12) angeordneter Substratträger (24) mit einem elektrischen Bias-Signal beaufschlagt wird.

5. Verfahren nach Anspruch 4, **dadurch gekennzeichnet, dass** das Bias-Signal mit wenigstens einem der drei Anregungsformen (60, 62, 64) des Magnetrons (16; 16a, 16b) synchronisiert wird.

6. Verfahren nach Anspruch 4 oder 5, **dadurch gekennzeichnet, dass** das Bias-Signal ein DC-, Hochfrequenz -Signal und/oder ein Pulssignal umfasst.

7. Verfahren nach Anspruch 6, **dadurch gekennzeichnet, dass** das das Pulssignal des Bias-Signals gegenüber der zweiten Anregungsform (62) zeitverzögert ist.

8. Verfahren nach einem der vorhergehenden Ansprüche, **dadurch gekennzeichnet, dass** ein einzelnes Magnetron (16) verwendet wird und dass das Bezugspotential für alle drei Anregungsformen (60, 62, 64) das Erdpotential ist.

9. Verfahren nach einem der vorhergehenden Ansprüche, **dadurch gekennzeichnet, dass** vor den hochenergetischen Impulsen der zweiten Anregungsform (62) kurze Vorimpulse abgegeben werden, um die Ionisierung in der Abscheidungskammer (12) zu erhöhen.

10. Magnetronsputteranlage zum Abscheiden von Schichten auf einem Substrat, umfassend eine Abscheidungskammer (12), eine Substrathalterung (24), als auch wenigstens ein in der Abscheidungskammer (12) angeordnetes Magnetron (16; 16a, 16b), das mit wenigstens einer Energieversorgung (30; 30a) verbunden ist, deren Ausgang drei Anregungsformen (60, 62, 64) an das wenigstens eine Magnetron (16; 16a, 16b) abgibt, umfassend eine erste Anregungsform (60), die durch eine Hochfrequenz-Spannung mit einer Frequenz von 1 MHz bis 10 GHz gebildet ist, eine zweite Anregungsform (62), die gebildet ist durch hochenergetische Impulse (HIPIMS) mit einer Frequenz von 100 Hz bis 5 kHz, und eine dritte Anregungsform (64), gebildet durch eine gepulste Gleichspannung oder Wechselspannung mit einer Frequenz zwischen 10 kHz und 100 kHz.

11. Magnetronsputteranlage nach Anspruch 10, **dadurch gekennzeichnet, dass** die Energieversorgung (30; 30a) für die Bereitstellung der drei Anregungsformen (60, 62, 64) separate Generatoren (32; 34) aufweist.

12. Magnetronsputteranlage nach Anspruch 10 oder 11, **dadurch gekennzeichnet, dass** sie eine Synchronisationseinrichtung (54) zur Synchronisierung von wenigstens zwei der drei Anregungsformen (60, 62, 64) aufweist.

13. Magnetronsputteranlage nach einem der Ansprüche 10 bis 12, **dadurch gekennzeichnet, dass** die Substrathalterung (24) gegenüber der Abscheidungskammer (12) isoliert und mit wenigstens einer BIAS-Energieversorgung (42) verbunden ist.

14. Magnetronsputteranlage nach Anspruch 13, **dadurch gekennzeichnet, dass** die Synchronisationseinrichtung (54) ausgebildet ist, die BIAS-Energieversorgung (42) mit der wenigstens einen Energieversorgung (30; 30a) zu synchronisieren.

15. Magnetronsputteranlage nach Anspruch 13 oder 14, **dadurch gekennzeichnet, dass** die wenigstens eine BIAS-Energieversorgung (42) ausgebildet ist, folgende Ausgangsspannungen an die Substrathalterung abzugeben: Gleichspannung, Hochfrequenzwechselspannung mit einer Frequenz von 1 MHz bis 10 GHz und/oder hochenergetische Impulse mit einer Frequenz von 10 kHz bis 100 kHz.

16. Magnetronsputteranlage nach einem der Ansprüche 10 bis 15, **dadurch gekennzeichnet, dass** die Synchronisationseinrichtung (54) mit wenigstens einer Messschaltung (28) verbunden ist, die mit den Ausgängen der wenigstens einen Energieversorgung (30; 30a) und optional auch mit dem Ausgang der BIAS-Energieversorgung (42) verbunden ist, welche Messschaltung (28) der Synchronisationseinrichtung (54) ein Korrektursignal für die Ansteuerung der wenigstens einen Energieversorgung (30; 30a) und optional auch der BIAS-Energieversorgung (42) liefert.
